Europäisches Patentamt

European Patent Office

Office européen des brevets

(11) Veröffentlichungsnummer : **0 317 853 B1**

# EUROPÄISCHE PATENTSCHRIFT

(45) Veröffentlichungstag der Patentschrift :
21.08.91 Patentblatt 91/34

(51) Int. Cl.$^5$ : **G01R 33/38**

(21) Anmeldenummer : 88118878.3

(22) Anmeldetag : 11.11.88

(54) **Magnetische Einrichtung einer Anlage zur Kernspintomographie mit supraleitenden Grundfeldspulen und normalleitenden Gradientenspulen.**

(30) Priorität : 24.11.87 DE 3739838

(43) Veröffentlichungstag der Anmeldung :
31.05.89 Patentblatt 89/22

(45) Bekanntmachung des Hinweises auf die
Patenterteilung :
21.08.91 Patentblatt 91/34

(84) Benannte Vertragsstaaten :
DE GB

(56) Entgegenhaltungen :
EP-A- 0 139 308
EP-A- 0 144 171
EP-A- 0 164 199

(56) Entgegenhaltungen :
EP-A- 0 216 590
EP-A- 0 231 879
REVIEW OF SCIENTIFIC INSTRUMENTS,
Band 53, Nr. 4, April 1982, Seiten 485-490,
American Institute of Physics, New York, US;
K.A. MUETHING et al.: "Small solenoid with a
superconducting shield for nuclear-magne-
tic-resonance near 1mK"Zusammenfassung;
Abschnitte "Introduction " und "Results"

(73) Patentinhaber : Siemens Aktiengesellschaft
Wittelsbacherplatz 2
W-8000 München 2 (DE)

(72) Erfinder : Siebold, Horst, Dr.
Reuthlehenstrasse 63
W-8520 Erlangen (DE)

## Beschreibung

Die Erfindung bezieht sich auf eine magnetische Einrichtung einer Anlage zur Kernspintomographie mit supraleitenden, von einem kryogenen Medium gekühlten Spulen zur Erzeugung eines homogenen magnetischen Grundfeldes, mit normalleitenden Spulen innerhalb des von den Grundfeldspulen umgrenzten Innenraumes zur Ausbildung magnetischer Feldgradienten sowie mit mindestens einem gekühlten Strahlungsschild aus elektrisch und thermisch leitendem Material, der zwischen den normalleitenden Gradientenspulen und den supraleitenden Grundfeldspulen angeordnet ist. Eine derartige magnetische Einrichtung ist in der EP-A-0144171 angedeutet.

Auf dem Gebiet der medizinischen Technik sind bildgebende Diagnoseverfahren entwickelt worden, bei denen rechnerisch und meßtechnisch integrale Resonanzsignale von Kernen eines bestimmten chemischen Elementes eines zu untersuchenden, insbesondere menschlichen Körpers oder Körperteiles analysiert werden. Aus der so zu gewinnenden räumlichen Spindichte- und/oder Relaxationszeitverteilung läßt sich dann ein Bild ähnlich wie die Röntgentomogramme der Computertomographie rekonstruieren bzw. berechnen. Entsprechende Verfahren sind allgemein unter der Bezeichnung "Kernspintomographie" (Nuclear Magnetic Resonance Tomography bzw. Magnetic Resonance Imaging oder -Spectroscopy) bekannt.

Voraussetzung für die Kernspintomographie ist ein von einem sogenannten Grundfeldmagneten erzeugtes Magnetfeld, in das ein zu untersuchender Körper oder Körperteil längs einer Achse, die im allgemeinen mit der Orientierungsachse des magnetischen Grundfeldes übereinstimmt, eingebracht wird. Das Grundfeld muß in einem entsprechenden Abbildungs- bzw. Untersuchungsbereich hinreichend homogen sein, wobei seine magnetische Induktion dort bis zu mehreren Tesla betragen kann. Solch hohe magnetische Induktionen lassen sich wirtschaftlich jedoch nur mit supraleitenden Magnetspulen erzeugen, die in einem entsprechenden Kryosystem unterzubringen sind. Ein solches Kryosystem umfaßt auch mindestens einen gekühlten Strahlungsschild, um eine Wärmeeinleitung von Raumtemperatur auf die supraleitenden Grundfeldspulen zu begrenzen. Entsprechende Strahlungsschilde werden deshalb im allgemeinen aus thermisch und damit auch aus elektrisch gut-leitendem Material erstellt. Das magnetische Grundfeld wird von stationären und/oder gepulsten, sogenannten Gradientenfeldern überlagert, welche von normalleitenden Spulen hervorgerufen werden, die innerhalb des von dem Kryosystem der Grundfeldspulen umgrenzten Innenraumes angeordnet sind und im allgemeinen auf etwa Raumtemperatur liegen. Zur Anregung der einzelnen Atomkerne in dem Körper bzw. Körperteil zu einer Präzessionsbewegung ist ferner eine besondere Antenneneinrichtung erforderlich, mit der kurzfristig ein hochfrequentes magnetisches Wechselfeld zu erzeugen ist. Gegebenenfalls läßt sich diese Antenneneinrichtung auch zum Empfang der so von den angeregten Atomkernen hervorgerufenen hochfrequenten Signale verwenden.

Gemäß der eingangs genannten EP-A ist der Strahlungsschild eines supraleitenden Grundfeldspulensystems bzw. seines Kryosystems aus einem elektrisch gut-leitenden Material wie z.B. aus Aluminium erstellt. In einem solchen Strahlungsschild werden jedoch von den normalleitenden Gradientenspulen Wirbelströme induziert, die ihrerseits wieder rückwirkend Gradientenfelder im Nutzvolumen des Untersuchungsbereiches erzeugen. Ohne besondere Gegenmaßnahmen bewirkt dies aber Unschärfen der zu gewinnenden Bilder. In diesem Zusammenhang ist es bei den Strahlungsschilden bekannter magnetischer Einrichtungen im allgemeinen auch nicht praktikabel, diese nicht-schirmend z.B. durch Verwendung elektrisch schlecht-leitenden Materials oder mit einer Schlitzung auszuführen. Dann könnten nämlich die Gradientenfelder bis in den heliumkalten Bereich der supraleitenden Grundfeldspulen dringen und dort bei sehr tiefer Betriebstemperatur besonders störende Wärmemengen hervorrufen.

Im Zusammenhang mit dieser Problematik sind hauptsächlich zwei Gegenmaßnahmen bekannt, die jedoch verhältnismäßig aufwendig sind :

1) Das Magnetfeld der in einem entsprechenden Strahlungsschild induzierten Wirbelströme beträgt etwa 10 bis 30% des direkten Gradientenfeldes. Das damit verbundene Feld ist dem ursprünglichen entgegengestezt ; d.h., es schwächt dieses also ab. Dieser Effekt kann bei der Auslegung und Gestaltung der Gradientenspulen berücksichtigt werden (vgl. z.B.. "J. Phys.E", Vol. 19, 1986, Seiten 876 bis 879 oder die EP-A-0164199).

2) Ferner ist z.B. aus "J.Phys.D", Vol. 19, 1986, Seiten L129 bis L131 bekannt, ein zusätzliches System von Gradientenspulen einzuführen, welches zwischen dem eigentlichen, primären Gradientenspulensystem und dem Strahlungsschild möglichst dicht an diesem Schild angeordnet wird. Hierbei führen aber die beengten Platzverhältnisse im Inneren der im allgemeinen solenoidartigen supraleitenden Grundfeldspulen zu Schwierigkeiten.

Aufgabe der vorliegenden Erfindung ist es nun, die magnetische Einrichtung der eingangs genannten Art dahingehend auszugestalten, daß die bei den bekannten Gegenmaßnahmen auftretenden Probleme aufgrund von Wirbelstrombildungen in dem Strahlungsschild verringert sind. Dabei soll jedoch die thermische Abschirmwirkung des Strahlungsschildes zumindest weitgehend erhalten bleiben.

Diese Aufgabe wird erfindungsgemäß dadurch gelöst, daß auf der dem Innenraum zugewandten Seite der Grundfeldspulen eine zumindest weitgehend rohrförmige Abschirmstruktur angeordnet ist, die supraleitendes Material zweiter Art zumindest enthält und die thermisch an das kryogene Medium der Grundfeldspulen angekoppelt ist, und daß der Strahlungsschild zur Unterdrückung von in ihm zumindest durch die Gradientenspulen induzierten Wirbelströmen ausgestaltet ist.

Unter einem supraleitenden Material zweiter Art (oder vom Typ II) wird hierbei allgemein jedes Material verstanden, das während des ungestörten Betriebszustandes der magnetischen Einrichtung im stationären Feld der Grundfeldspulen und in dem Wechselfeld der Gradienten- und HF-Spulen eine hinreichende Stromdichte (Stromtragfähigkeit) aufweist, um die in ihm induzierten Ströme zumindest weitgehend verlustfrei tragen zu können, ohne daß diese aufgrund eines elektrischen Widerstandes mit der Zeit abgeschwächt werden. Dabei soll das magnetische Grundfeld das supraleitende Material durchdringen können (vgl. z.B. Lehrbuch von W.Buckel : "Supraleitung", 3. Auflage, Weinheim 1984, Seiten 140 bis 166 oder "Elektrotechnik und Maschinenbau", Jg. 96, H. 4, 1979, Seiten 137 bis 156).

Die mit der erfindungsgemäßen Ausgestaltung der magnetischen Einrichtung verbundenen Vorteile sind insbesondere darin zu sehen, daß die Funktion von thermischer Abschirmung und elektromagnetischer Abschirmung der Gradientenfelder gegenüber dem Kryobereich der supraleitenden Grundfeldspulen nunmehr entkoppelt sind. Dabei wird das Grundfeld wegen der Verwendung eines Supraleiters zweiter Art nur geringfügig aufgrund eines geringen restlichen Diamagnetismus' aus der schichtartigen Struktur herausgedrängt und damit im Nutzvolumen entsprechend wenig verändert. Die im Betriebsfall auftretenden Gradientenfelder werfen also in der schichtartigen Struktur Ströme an, die nicht mehr durch Joule'sche Verluste gedämpft sind. Der Frequenzgang ist deshalb bis zu tiefsten Frequenzen hinab weitgehend glatt.

Ein weiterer Vorteil besteht darin, daß sich nun Strahlungsschilde verwenden lassen, die unter dem Gesichtspunkt einer Unterdrückung von Wirbelstrombildung aufgrund der Gradientenfelder ausgestaltet sind. Entsprechende Maßnahmen zur Wirbelstromunterdrückung sind allgemein bekannt. Diese Maßnahmen können insbesondere noch mit sich bringen, daß bei einem eventuellen Quench der Grundfeldspulen, d.h. bei deren unbeabsichtigten Übergang vom supraleitenden in den normalleitenden Zustand, vorteilhaft keine großen Wirbelströme und damit Kräfte in dem Strahlungsschild auftreten.

Ein weiterer Vorteil der erfindungsgemäßen Maßnahmen ist darin zu sehen, daß zeitabhängige äußere Störfelder, die z.B. nach einem sogenannten Shimmen (Homogenisieren) der Grundfeldspulen auftreten, weitgehend vom Nutzvolumen ferngehalten werden.

Vorteilhafte Ausgestaltungen der magnetischen Einrichtung nach der Erfindung gehen aus den Unteransprüchen hervor.

Zur weiteren Erläuterung der Erfindung wird nachfolgend auf die schematische Zeichnung Bezug genommen, in deren Figuren 1 und 2 eine magnetische Einrichtung mit einem Strahlungsschild angedeutet ist. Die Figuren 3 und 4 zeigen zwei Ausführungsformen von Abschirmstrukturen dieser Einrichtung. In den Figuren 5 bis 7 sind weitere Ausbildungsmöglichkeiten von Abschirmstrukturen veranschaulicht. In den Figuren 8 bis 11 sind Heizvorrichtungen an Abschirmstrukturen dargestellt. Die Figuren 12 und 13 zeigen jeweils eine Ausbildungsmöglichkeit eines Strahlungsschildes für eine erfindungsgemäße magnetische Einrichtung. In den Figuren übereinstimmende Teile sind mit demselben Bezugszeichen versehen.

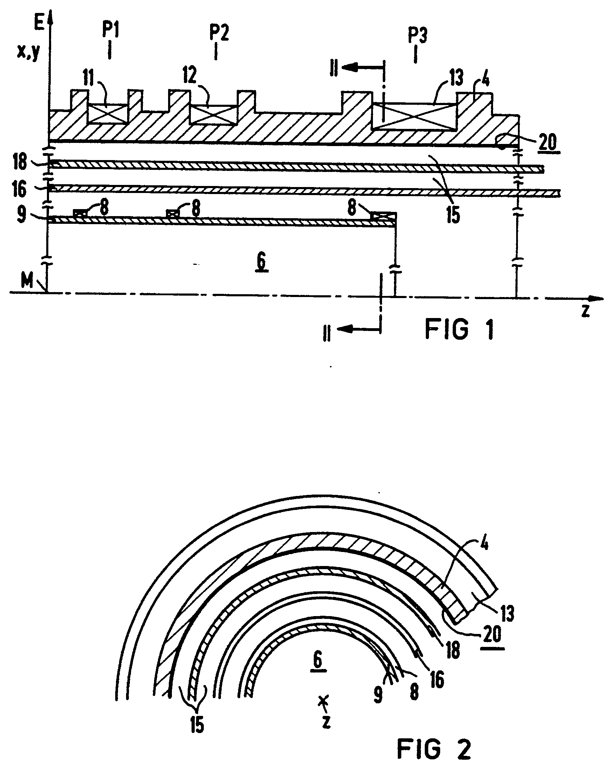

Bei der erfindungsgemäßen magnetischen Einrichtung gemäß Figur 1 wird von bekannten Ausführungsformen ausgegangen, wie sie für bildgebende Anlagen zur Kernspintomographie vorgesehen werden (vgl. z.B. die genannten EP-A-0144171). Eine solche Einrichtung enthält dabei im allgemeinen mehrere Paare von supraleitenden Spulen zur Erzeugung eines magnetischen Grundfeldes in Richtung der z-Achse eines rechtwinkligen x-y-z-Koordinatensystems. Dieses Grundfeld ist in einem Abbildungsbereich bzw. Nutzvolumen, in dessen zentraler Mitte M sich der Koordinatenursprung dieses Koordinatensystems befinden soll, hinreichend homogen. Die magnetische Einrichtung soll einen axialen Zugang zu diesem homogenen Abbildungsbereich erlauben ; d.h., ein zu untersuchender beispielsweise menschlicher Körper wird längs der z-Achse in diesen Feldbereich eingebracht. Entsprechende magnetische Einrichtungen werden deshalb vorzugsweise rotationssymmetrisch aufgebaut. Die in Figur 1 nur schematisch als Längsschnitt teilweise angedeutete und allgemein mit 2 bezeichnete magnetische Einrichtung zur Kernspintomographie soll z.B. sechs längs der z-Achse hintereinandergereihte, ringförmige supraleitende Grundfeldspulen aufweisen. Jeweils zwei dieser Spulen sind bezüglich der durch die x-y-Achsen des Koordinatensystems aufgespannten Ebene E symmetrisch angeordnet, so daß sich drei Paare P1, P2 und P3 von Grundfeldspulen ergeben. In der Figur sind nur die auf der einen Seite dieser Symmetrieebene E und oberhalb der z-Achse liegenden Teile der magnetischen Einrichtung 2 näher ausgeführt. Es sind somit das Spulenpaar P1 durch seine Grundfeldspule 11, das Spulenpaar P2 durch seine Grundfeldspule 12 und das Spulenpaar P3 durch seine Grundfeldspule 13 veranschaulicht. Dabei können die Grundfeldspulen der magnetischen Einrichtung insbesondere in entsprechenden Nuten eines massiven hohlzylindrischen Spulenkörpers 4 aus nicht-magnetischem Material angeordnet sein (vgl. z.B. EP-A-0238909). Dieser Spulenkörper wird von dem zur Kühlung der supraleitenden Grundfeldspulen erforderlichen kryogenen Medium mitgekühlt. Innerhalb des von den Spulenpaaren bzw. ihrem gemeinsamen Spulenkörper 4 begrenzten zylindrischen Innenraumes 6 der magnetischen Einrichtung 2 sind außerdem an sich bekannte normalleitende Gradientenspulen und ferner noch normalleitende HF-Spulen anzuordnen. In der Figur sind lediglich beispielsweise sattelförmige x-y-Gradientenspulen angedeutet und mit 8 bezeichnet. Diese beispielsweise auf einem rohrförmigen Träger 9 befestigten Gradientenspulen 8 befinden sich etwa auf Raumtemperatur, so daß eine thermische Abschirmung zwischen ihnen und den tiefgekühlten supraleitenden Grundfeldspulen 11 bis 13 erforderlich ist. Hierzu dient ein Vakuumraum 15, der den Spulenkörper 4 mit den supraleitenden Grundfeldspulen 11 bis 13 umgibt. In diesem von einem entsprechenden Vakuumgefäß 16 eingeschlossenen Vakuumraum 15 ist konzentrisch mindestens ein vielfach auch als Kälteschild oder Strahlungsschild bezeichneter thermischer Schild 18 angeordnet, der so ausgestaltet ist, daß in ihm durch die Gradientenspulen induzierte Wirbelströme zumindest weitgehend unterdrückt sind. Das Vakuumgefäß 16 besteht vorteilhaft aus einem elektrisch schlecht-leitenden Material wie z.B. aus Edelstahl oder aus glasfaserverstärktem Kunststoff.

In Figur 2 ist schematisch ein Querschnitt durch die in Figur 1 gezeigte magnetische Einrichtung 2 längs einer mit II-II bezeichneten Schnittebene wiedergegeben.

Gemäß der Erfindung soll auf der dem Innenraum 6 zugewandten Seite der supraleitenden Grundfeldspulen 11 bis 13 eine elektro-magnetische Abschirmstruktur 20 vorgesehen sein, mit der die Gradientenfelder am Eindringen in den Kryobereich der Grundfeldspulen gehindert werden. Hierzu soll die zumindest weitgehend rohrförmige Struktur aus einem supraleitenden Material zweiter Art bzw. vom Typ II bestehen oder Teile aus diesem Material enthalten. Die Struktur ist gemäß dem in den Figuren 1 und 2 gezeigten Ausführungsbeispiel direkt an der Innenseite des Spulenkörpers 4 in Form einer Schicht oder eines Filmes aus dem supraleitenden Material angebracht. Auf diese Weise wird ein thermischer Kontakt mit dem kalten Spulenkörper gewährleistet, so daß die Schicht im Normalbetrieb unterhalb der Sprungtemperatur ihre supraleitenden Materials zu halten ist. Die als Abschirmstruktur 20 dienende Schicht kann gegebenenfalls direkt auf den Spulenkörper z.B. durch Sputtern oder Verdampfen aufgebracht sein.

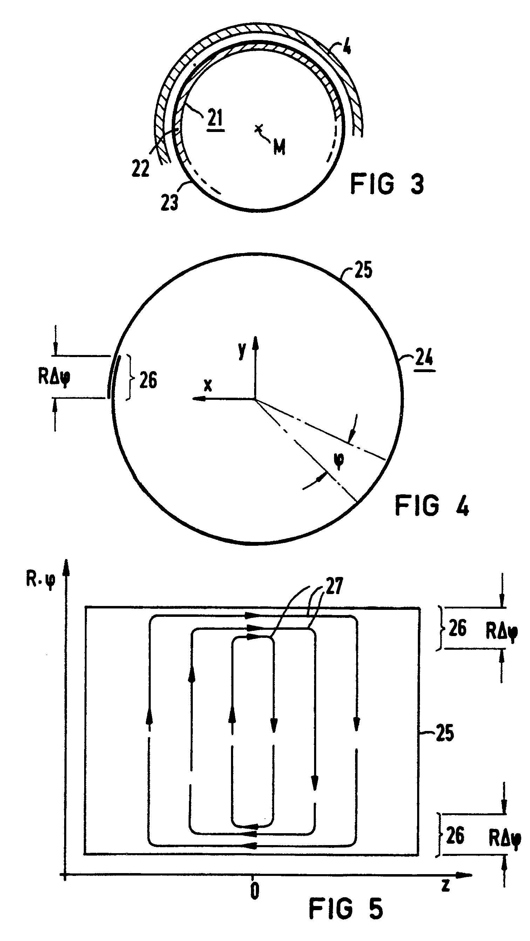

Wie in Figur 3 als Schnitt schematisch angedeutet ist, läßt sich für eine Abschirmstruktur 21 gegebenenfalls auch ein besonderer Zylindermantel 22 aus z.B. elektrisch und magnetisch nicht-leitendem Material verwenden, der lediglich einer supraleitenden Schicht 23 als Träger dient. Falls dabei kein unmittelbarer Kontakt mit dem kalten Spulenkörper 4 besteht, muß in bekannter Weise zusätzlich eine Kühlvorrichtung für die supraleitende Schicht 23 vorgesehen werden.

Im allgemeinen ist jedoch nicht unbedingt erforderlich, daß die supraleitende Schicht 23 gemäß Figur 3 eine geschlossene Zylinderfläche einer Abschirmstruktur darstellt, um die Gradientenfelder abschirmen zu können. Dies wäre nur notwendig, wenn auch ein Homogenfeld, insbesondere vom Typ des Grundfeldes, abzuschirmen wäre. Stattdessen kann gemäß den skizzenhaften Figuren 4 und 5 auch eine rechteckige supraleitende Folie 25 der Abmessung $(2\pi + \Delta\varphi) \cdot R \cdot$ z-Länge hergestellt werden, die nach Einbringen in den Spulenkörper 4 eine Überlappung $R \cdot \Delta\varphi$ aufweist. Dabei sind R der Radius der zu einer rohrförmigen Struktur gebogenen supraleitenden Folie 25 und $\varphi$ der azimutale Winkel in einem x-y-z-Koordinatensystem (vgl. Fig. 4). Wirbelströme, auch in azimutaler $\varphi$-Richtung, wie sie von z-Gradienten induziert werden, können sich dann in einem Überlappungsbereich 26 der Größe $R \cdot \Delta\varphi$ schließen. Entsprechende Wirbelströme sind in der Skizze der Figur 5 angedeutet und mit 27 bezeichnet. In dieser Figur ist die Folie 25 aus Figur 4 in einer R $\varphi$-z-Ebene ausgebreitet dargestellt.

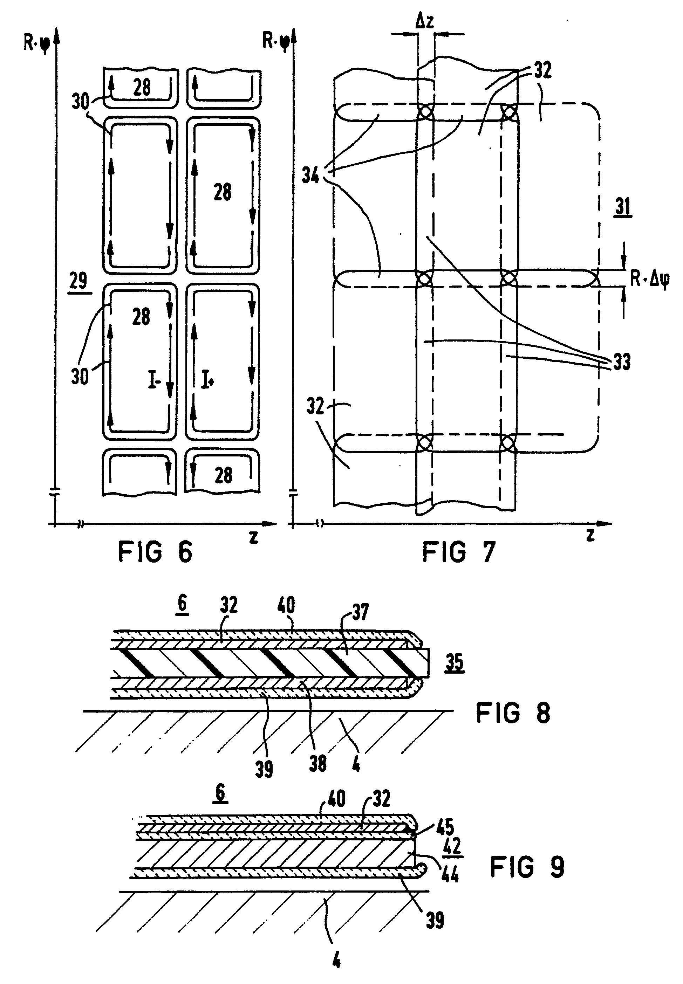

Gemäß den Figuren 4 und 5 wurde davon ausgegangen, daß eine Folie 25 aus dem supraleitenden Material mit dem Abmessungen des Spulenkörpers 4 angepaßten, verhältnismäßig ausgedehnten Maßen vorhanden ist. Man kann jedoch die supraleitende Fläche der auszubildenden rohrförmigen Abschirmstruktur auch in handliche, preiswert zu fertigende Einzelflächen aufteilen. Mit z.B. rechteckigen oder sechseckigen Flächenelementen läßt sich dann die große Fläche lückenlos bedecken. Hierzu sei zunächst auf die Skizze der Figur 6 verwiesen, in der nur einige rechteckige Flächen- oder Schirmelemente 28 in Figur 5 entsprechender Darstellung angedeutet sind. Diese Schirmelemente einer Abschirmstruktur 29 sollen untereinander galvanisch (elektrisch leitend) nicht verbunden sein. Die in den Schirmelementen jeweils induzierten Wirbelströme müssen dann stets darauf geschlossene Stromschleifen 30 darstellen. Ein in Umfangsrichtung $\varphi$ induzierter, eigentlich erst über den gesamten Umfang geschlossener Wirbelstromring der Stärke $I_\varphi$, wie er z.B. von einer darunterliegenden z-Gradientenspule erzeugt würde, stellt sich dann als Differenz der Kantenströme $I_-$ und $I_+$ benachbarter Elemente dar. Dies führt dazu, daß die Stromdichten an den Kanten besonders groß sind. Das supraleitende Material muß deshalb eine entsprechend hohe Stromtragfähigkeit aufweisen.

Eine besonders vorteilhafte Ausführungsform einer erfindungsgemäßen rohrförmigen supraleitenden Abschirmstruktur mit reduzierten Anforderungen an die Stromtragfähigkeit ihres supraleitenden Materials ist in der Skizze der Figur 7 in Figur 5 oder Figur 6 entsprechender Darstellung angedeutet. Hierbei wird die nur als Ausschnitt ausgeführte, allgemein mit 31 bezeichnete Struktur durch einzelne Schirmelemente 32 gebildet, die sich in Bereichen 33 und 34 um $\Delta$ z bzw. R $\cdot \Delta\varphi$ überlappen. Die in Figur 6 veranschaulichten Kantenströme verteilen sich dann auf eine endliche Breite, nämlich auf die radial übereinander angeordneten Überlappungsbereiche, und können auf einen gewünschten Strombelag K = I/ $\Delta$z bzw. I/R $\cdot \Delta\varphi$ begrenzt werden. Hierbei ist vorteilhaft die Überlappungsweise — also : in welcher Reihenfolge die Elemente von innen an den Spulenkörper montiert werden — von ihrer Funktion her gleichgültig und kann somit aus rein fertigungstechnischen Aspekten bestimmt werden. Stehen z.B. langgestreckte Bahnen aus einer Meterwaren-Herstellung zur Verfügung, so lassen sich die in Figur 7 gezeigten Spezialfälle realisieren : Nämlich durchgehende Streifen in z-Richtung mit R $\cdot \Delta\varphi$ -Überlappung, oder einmal den Zylinderumfang umschlingende Streifen mit nur einer R $\cdot \Delta\varphi$ -Überlappung und jeweils $\Delta$z-Überlappungen.

Zur Bestimmung der erforderlichen Schichtdicken des zu verwendenden supraleitenden Materials kann man ohne weiteres die sich maximal einstellenden Strombeläge K abschätzen. Daraus folgt, daß für handelsübliche Kernspintomographieanlagen die Schichtdicken in der Größenordnung zwischen 0,5 µm und 5 µm liegen. Selbstverständlich können auch dickere Schichten vorgesehen werden.

Die Herstellung der einzelnen Schirmelemente nach den Figuren 6 und 7 kann mittels bekannter Technologien erfolgen. So lassen sich z.B. supraleitende Schichten durch Sputtern, insbesondere durch DC-Magnetron-Sputtern, auf eine Kunststoffolie aufbringen, wobei entweder mit der bereits fertigen Legierung gesputtert wird oder man zwei Quellen mit den jeweiligen Ausgangsmaterialien des Supraleiters arbeitet. Für die erfindungsgemäße Abschirmstruktur geeignete Materialien sind allgemein bekannt (vgl. z.B. EP-A-0190767). Vorgefertigte, ausgewalzte Folien, z.B. NbTi-Folien, können auf einem Träger aufgeklebt werden. Um eventuelle auftretende Probleme hinsichtlich einer Sprödigkeit des supraleitenden Materials zu umgehen, kann man gegebenenfalls auch das supraleitende Material in bekannter Weise "in situ", d.h. erst in annähernd endgültiger Form erzeugen. So läßt sich z.B. eine Nb-Folie mit Ti besputtern und erst nach endgültiger Formgebung durch einen Diffusionsprozeß mittels einer Wärmebehandlung zu einer gewünschten NbTi-Schicht präparieren. Ferner kann man z.B. das Nb auch elektrolytisch auf einen hitzebeständigen Träger abscheiden und das Ti wieder mittels Sputtern und Diffusion einbringen.

Bei Feldänderungen der Grundfeldspulen, z.B. bei deren Auferregen, werden in den z.B. in den Figuren 6 und 7 gezeigten Schirmelementen 28 bzw. 32 ebenfalls Wirbelströme induziert. Diese Wirbelströme müssen exakt auf Null gebracht werden, damit die berechnete Homogenität des von den Grundfeldspulen zu erzeugenden Magnetfeldes erreicht wird. Im allgemeinen kann davon ausgegangen werden, daß die supraleitende Schicht der erfindungsgemäßen rohrförmigen Abschirmstruktur quencht, d.h. in die Normalleitung übergeht, und dadurch die Wirbelströme im wesentlichen automatisch abgebaut werden. Vorteilhaft ist es jedoch, eine besondere Heizungsvorrichtung der jeweiligen rohrförmigen Struktur vorzusehen, um wohldefiniert den stromfreien Zustand jederzeit erreichen zu können.

Hierzu müssen die einzelnen Schirmelemente jeweils zusätzlich eine normalleitende Beschichtung, z.B. aus Kupfer oder Aluminium besitzen, oder ihr Träger selbst besteht aus einem elektrisch leitfähigen Material. Die Heizvorrichtungen der einzelnen Schirmelemente müssen elektrisch untereinander verbunden werden, so daß mittels geeigneter Serien- bzw. Parallelschaltung ein gewünschter Gesamtwiderstand entsteht und eine Anschlußleitung aus einem Kryosystem anzubringen ist.

Außerdem muß eine als Heizvorrichtung dienende normalleitende Schicht elektrisch isoliert sien von dem supraleitenden Material, damit sie nicht von diesem kurzgeschlossen wird. Aus dem gleichen Grund muß eine entsprechende Heizleiterschicht auch gegenüber dem Spulenkörper isoliert werden, falls dieser aus elektrisch leitendem Material gefertigt ist ; dies kann z.B. durch eine separate Kunststoffolie oder durch eine Isolierschicht erreicht werden. Je einen entsprechenden Schichtaufbau zeigen schematisch die Figuren 8 und 9 als Ausschnitt.

Gemäß Figur 8 ist von einer rohrförmigen supraleitenden Abschirmstruktur 35 ausgegangen, deren supraleitende Schirmelemente 32 auf einem besonderen Kunststoffträger 37 aufgebracht sind. Auf der dem Spulenkörper 4 zugewandten Seite dieses Kunststoffträgers 37 ist eine Heizleiterschicht 38 als Heizvorrichtung angeordnet. Diese Heizleiterschicht 38 ist gegenüber dem elektrisch leitenden Spulenkörper 4 durch eine Isolationsschicht 39 isoliert. Die supraleitenden Schirmelemente 32 werden also vorteilhaft stets nach innen, den nicht gezeigten Gradientenspulen zugewandt angeordnet. Sie sind durch eine weitere Isolationsschicht 40 nach innen hin abgedeckt.

Gemäß dem in Figur 9 gezeigten Aufbau wird von einer supraleitenden Abschirmstruktur 42 ausgegangen, deren supraleitende Schirmelemente 32 von einem metallischen Körper 44 getragen werden. Dieser Körper 44 dient gleichzeitig als Heizvorrichtung. Er ist gegenüber den supraleitenden Schirmelementen 32 durch eine besondere Isolationsschicht 45 getrennt.

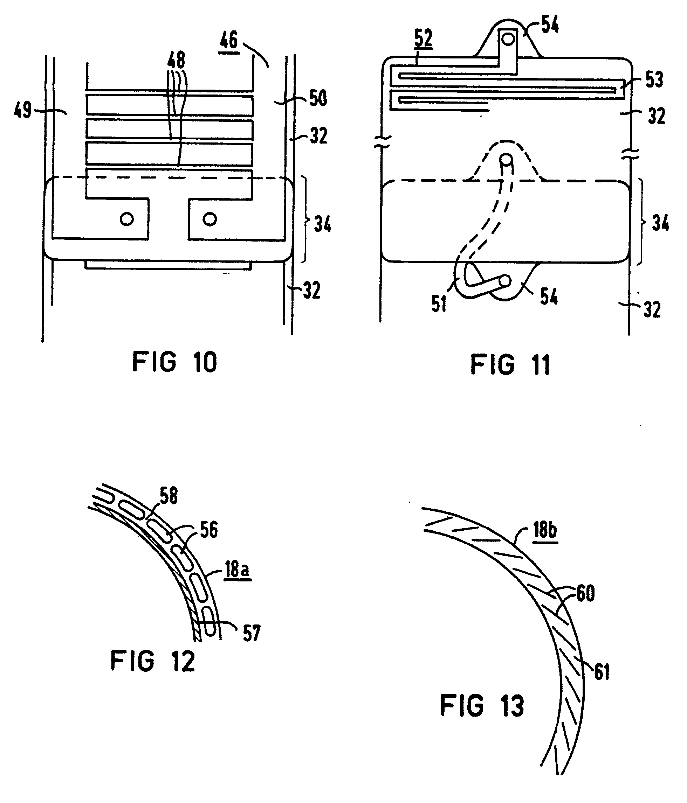

In den Figuren 10 und 11 sind Kontaktierungsmöglichkeiten der einzelnen Schirmelementen zugeordneten Heizvorrichtungen schematisch veranschaulicht.

So sind in Figur 10 zwei Schirmelemente angedeutet, bei denen es sich z.B. um die Elemente 32 gemäß Figur 7 handeln kann. Diese Elemente bilden einen Überlappungsbereich 34 aus. Um eine Parallelschaltung der Heizkreise einer Heizvorrichtung 46 zu ermöglichen, sind zwei Kontakt pro Kante erforderlich. Die Stromversorgung zum nächsten Element hin erfordert zwei kontaktierte Kanten. Die entsprechenden Kontakte sind hier realisiert mittels durchgesteckter Nieten oder Schrauben. Um die Durchbrüche herum sollte die supraleitende Schicht des jeweiligen Elementes etwas freigehalten sein, um so Kurzschlüsse zu vermeiden. Die Joule'sche Heizleistung wird in den dünnen Stegen 48 umgesetzt, die zwischen den Leiterbahnen 49 und 50 an den Kanten der einzelnen Elemente verlaufen. Die restliche Fläche wird durch Wärmeleitung im Element mitgeheizt.

Gemäß Figur 11 sind Schirmelemente 32 vorgesehen, deren Heizvorrichtungen 52 mittels flexiblem Leiterband 51 im Überlappungsbereich 34 der Elemente zu einer Serienschaltung verbunden sind. Hier bietet sich eine mäanderförmige Struktur einer Heizschicht 53 an. Diese Schicht mündet in Nasen 54, die frei von dem supraleitenden Material sind. Die einzelnen Schirmelemente können dann quasi zu einer Kette vormontiert in den Spulenkörper eingebracht werden und brauchen dort nur noch mechanisch fixiert zu werden. Hierzu lassen sich beispielsweise Schrauben oder Klipse vorsehen, die vorteilhaft im Zentrum der einzelnen Elemente angeordnet sind.

Selbstverständlich kann die Kontakttechnik nach Figur 10 auch mit der Serienschaltung nach Figur 11 und umgekehrt kombiniert werden.

Gemäß der Erfindung wird eine elektromagnetische Abschirmung der Gradientenfelder gegenüber den supraleitenden Grundfeldspulen 11 bis 13 mit den in den Figuren gezeigten supraleitenden Abschirmstrukturen bewirkt. Der für die erfindungsgemäße Magneteinrichtung zusätzlich noch erforderliche mindestens eine Strahlungsschild 18 braucht dann nicht unter den Gesichtspunkten einer elektromagnetischen Abschirmung ausgelegt zu werden. Man kann ihn deshalb in an sich bekannter Weise so ausgestalten, daß in ihm durch die Gradientenspulen oder im Falle eines Quenches einer Grundfeldspule keine großen Wirbelströme und damit gegebenenfalls auch keine zu großen Kräfte auftreten. Aus diesem Grunde wird der Strahlungsschild vorteilhaft mit einer Längsschlitzung versehen. Als ein Ausführungsbeispiel ist ein Teil eines entsprechenden Strahlungsschildes in Figur 12 als Querschnitt schematisch veranschaulicht und mit 18a bezeichnet. Dieser Schirm setzt sich im wesentlichen aus einer Vielzahl von dünnwandigen Rohren zusammen, die z.B. aus Edelstahl bestehen. Diese Rohre erstrecken sich untereinander parallelliegend in axialer (z–) Richtung und liegen in Umfangsrichtung gesehen eng nebeneinander. Jedoch sollen sie untereinander vorteilhaft elektrisch isoliert sein. Gemäß dem dargestellten Ausführungsbeispiel sind hierzu die einzelnen, mit 56 bezeichneten Rohre auf einem dünnen rohrförmigen Träger 57 elektrisch isoliert aufgebracht, z.B. aufgeklebt. Die entsprechende Kleberschicht, welche die elektrische Isolation der Rohre 56 untereinander gewährleistet, ist in der Figur mit 58 bezeichnet. Es ergibt sich so ein längsgeschlitzter Aufbau des Strahlungsschildes 18a.

Der dünne rohrförmige Träger 57 kann aus einem elektrisch schlecht-leitenden Blech wie z.B. aus Stahl oder aus Kunststoff bestehen. Gegebenenfalls ist es auch möglich, auf diesen Träger ganz zu verzichten. Die untereinander mechanisch verbundenen Kühlrohre 56 müssen dann eine hinreichend eigenstabile zylindrische Struktur darstellen und/oder an ihren Stirnseiten entsprechend stabil gehalten werden.

Aus Figur 13 geht eine weitere Ausführungsform eines längsgeschlitzten Strahlungsschildes in Figur 12 entsprechender Darstellung schematisch hervor. Dieser mit 18b bezeichnete Strahlungsschild setzt sich aus in Umfangsrichtung gesehen überlappenden, elektrisch gegeneinander isolierten Metallstreifen 60 zusammen, die zu einer rohrförmigen Struktur mittels einer elektrischen Isolation 61 verbunden sind. Die Metallstreifen 60 müssen hierbei aus einem gutwärmeleitenden Material bestehen, um die auftretende Wärmelast in axialer (z–) Richtung an die Stirnseiten des Strahlungsschildes abführen zu können. Dort sind sie thermisch an entsprechend kalte Teile der magnetischen Einrichtung angekoppelt.

## Patentansprüche

1. Magnetische Einrichtung einer Anlage zur Kernspintomographie mit supraleitenden, von einem kryogenen Medium gekühlten Spulen zur Erzeugung eines homogenen magnetischen Grundfeldes, mit normalleitenden Spulen innerhalb des von den Grundfeldspulen umgrenzten Innenraumes zur Ausbildung magnetischer Feldgradienten sowie mit mindestens einem gekühlten Strahlungsschild aus elektrisch und thermisch leitendem Material, der zwischen den normalleitenden Gradientenspulen und den supraleitenden Grundfeldspulen angeordnet ist, **dadurch gekennzeichnet,** daß auf der dem Innenraum (6) zugewandten Seite der Grundfeldspulen (11 bis 13) eine rohrförmige Abschirmstruktur (20, 21, 29, 31, 35, 42) angeordnet ist, die supraleitendes Material zweiter Art zumindest enthält und thermisch an das kryogene Medium der Grundfeldspulen angekoppelt ist, und daß der Strahlungsschild (18, 18a, 18b) zur Unterdrückung von in ihm zumindest durch die Gradientenspulen (8) induzierten Wirbelströmen ausgestaltet ist.

2. Magnetische Einrichtung nach Anspruch 1, **dadurch gekennzeichnet,** daß die Abschirmstruktur (20, 21, 24, 29, 31, 35, 42) das supraleitende Material in Form einer Schicht oder einer Folie enthält.

3. Magnetische Einrichtung nach Anspruch 2, **dadurch gekennzeichnet,** daß das supraleitende Material der Abschirmstruktur (21, 35, 42) auf einen Träger (22, 37, 44) aufgebracht ist.

4. Magnetische Einrichtung nach einem der Ansprüche 1 bis 3, **dadurch gekennzeichnet,** daß die Grundfeldspulen (11 bis 13) auf einem mitgekühlten Spulenkörper (4) angeordnet sind, an dessen Innenseite die Abschirmstruktur (20, 21, 24, 29, 31, 35, 42) angebracht ist.

5. Magnetische Einrichtung nach einem der Ansprüche 1 bis 4, **dadurch gekennzeichnet,** daß die Abschirmstruktur (24) aus einer rechteckigen supraleitenden Folie (25) ausgebildet ist, wobei ein Überlappungsbereich (26) an den Längskanten der Folie ausgebildet ist.

6. Magnetische Einrichtung nach einem der Ansprüche 1 bis 4, **dadurch gekennzeichnet,** daß die Abschirmstruktur (29, 31) aus mehreren vorgefertigten Schirmelementen (28, 32) zusammengesetzt ist.

7. Magnetische Einrichtung nach Anspruch 6, **dadurch gekennzeichnet,** daß mit den Schirmelementen (32) an einander zugewandten Kanten Überlappungsbereiche (33, 34) ausgebildet sind.

8. Magnetische Einrichtung nach Anspruch 6 oder 7, **dadurch gekennzeichnet,** daß die einzelnen Schirmelemente (28, 32) rechteckige Gestalt haben.

9. Magnetische Einrichtung nach einem der Ansprüche 1 bis 8, **dadurch gekennzeichnet,** daß die Abschirmstruktur (35, 42) mit einer Heizvorrichtung (38, 46, 52) versehen ist, die gegenüber dem supraleitenden Material der Abschirmstruktur elektrisch isoliert ist.

10. Magnetische Einrichtung nach Anspruch 9, **dadurch gekennzeichnet,** daß die Heizvorrichtung eine Heizleiterschicht (38, 44, 53) enthält, die über eine Isolationsschicht (37, 45) thermisch an das supraleitende Material der Abschirmstruktur (35, 42) angekoppelt ist.

11. Magnetische Einrichtung nach einem der Ansprüche 1 bis 10, **dadurch gekennzeichnet,** daß der Strahlungsschild (18, 18a, 18b) einen längsgeschlitzten Aufbau seiner metallischen Teile aufweist.

12. Magnetische Einrichtung nach Anspruch 11, **dadurch gekennzeichnet,** daß der Strahlungsschild (18a) dünnwandige Kühlmittelrohre (56) enthält, die in axialer Richtung des schildes parallel zueinander und untereinander elektrisch schlecht-leitend angeordnet sind (Figur 12).

13. Magnetische Einrichtung nach Anspruch 11, **dadurch gekennzeichnet,** daß der Strahlungsschild (18b) dünne Metallstreifen (60) aus thermisch gut-leitendem Material enthält, die in axialer Richtung des Schildes parallel zueinander angeordnet sind und sich in Umfangsrichtung des Schildes gesehen überlappen, wobei sie untereinander elektrisch isoliert sind (Figur 13).

14. Magnetische Einrichtung nach einem der Ansprüche 1 bis 13, **dadurch gekennzeichnet,** daß die supraleitenden Grundfeldspulen (11 bis 13) und der mindestens eine Strahlungsschild (18, 18a, 18b) in einem Vakuumgefäß (16) angeordnet sind, das aus elektrisch schlecht-leitendem Material besteht.

## Claims

1. Magnetic device of an installation for nuclear spin tomography having superconducting coils which are cooled by a cryogenic medium for the purpose of generating a homogeneous magnetic background field, having normal-conducting coils within the interior space bounded by the background field coils for the formation of magnetic field gradients and also having at least one cooled radiation shield made of electrically and thermally conducting material which is arranged between the normal-conducting gradient coils and the superconducting background field coils, characterised in that there is arranged on the side of the background field coils (11 to 13) which faces the interior space (6) a tubular screening structure (20, 21, 29, 31, 35, 42) which at least contains superconducting material of second kind and is thermally coupled to the cryogenic medium of the background field coils and in that the radiation shield (18, 18a, 18b) is developed for the suppression of eddy currents induced therein at least by the gradient coils (8).

2. Magnetic device according to claim 1, characterised in that the screening structure (20, 21, 24, 29, 31, 35, 42) contains superconducting material in the form of a layer or a foil.

3. Magnetic device according to claim 2, characterised in that the superconducting material of the screening structure (21, 35, 42) is applied to a carrier (22, 37, 44).

4. Magnetic device according to one of the claims 1 to 3, characterised in that the background field coils (11 to 13) are arranged on a simultaneously cooled coil body (4), on the inside of which there is provided the screening structure (20, 21, 24, 29, 31, 35, 42).

5. Magnetic device according to one of the claims 1 to 4, characterised in that the screening structure (24) is formed of a rectangular superconducting foil (25), with an overlap region (26) being formed at the longitudinal edges of the foil.

6. Magnetic device according to one of the claims 1 to 4, characterised in that the screening structure (29, 31) is composed of several pre-fabricated screening elements (28, 32).

7. Magnetic device according to claim 6, characterised in that overlap regions (33, 34) are formed with the screening elements (32) at edges which face each other.

8. Magnetic device according to claim 6 or 7, characterised in that the individual screening elements (28, 32) have a rectangular shape.

9. Magnetic device according to one of the claims 1 to 8, characterised in that the screening structure (35, 42) is provided with a heating arrangement (38, 46, 52) which is electrically insulated in respect of the superconducting material of the screening structure.

10. Magnetic device according to claim 9, characterised in that the heating arrangement contains a heating conductor layer (38, 44, 53) which by way of an insulation layer (37, 45) is thermally coupled to the superconducting material of the screening structure (35, 42).

11. Magnetic device according to one of the claims 1 to 10, characterised in that the radiation shield (18, 18a, 18b) has a longitudinally slit structure of its metallic portions.

12. Magnetic device according to claim 11, characterised in that the radiation shield (18a) contains thin-walled coolant pipes (56) which are arranged so as to be parallel to each other in the axial direction of the shield and with poor mutual electrical conductivity (Figure 12).

13. Magnetic device according to claim 11, characterised in that the radiation shield (18b) contains thin metal strips (60) of material of high thermal conductivity, which strips are arranged so as to be parallel to each other in the axial direction of the shield and overlap, viewed in the peripheral direction of the shield, in which case they are electrically insulated in respect of each other (Figure 13).

14. Magnetic device according to one of the claims 1 to 13, characterised in that the superconducting background field coils (11 to 13) and the at least one radiation shield (18, 18a, 18b) are arranged in a vacuum tank (16) which consists of material with poor electrical conductivity.


## Revendications

1. Dispositif magnétique d'une installation pour la tomographie à spin nucléaire, avec des bobines à supraconduction, refroidies par un milieu cryogène, pour la production d'un champ magnétique de base homogène, avec des bobines à conduction normale dans l'espace intérieur délimité par les bobines du champ de base en vue de la formation de gradients de champ magnétique, ainsi qu'avec au moins un écran refroidi contre le rayonnement, en un matériau électriquement et thermiquement conducteur et disposé entre les bobines de gradients à conduction normale et les bobines de champ de base à supraconduction, caractérisé par le fait,que sur le côté des bobines de champ de base (11 à 13), qui est tourné vers l'espace intérieur (6), est disposée une structure à effet d'écran (20, 21, 29, 31, 35, 42), de forme tubulaire, qui comporte au moins un matériau supraconducteur du second genre et qui est couplée thermiquement au milieu cryogène des bobines de champ de base, et que l'écran contre le rayonnement (18, 18a, 18b) est réalisé en vue de la suppression des courants de Foucault qui y sont induits par les bobines de gradients (8).

2. Dispositif magnétique selon la revendication 1, caractérisé par le fait que la structure à effet d'écran (20, 21, 24, 29, 31, 35, 42) comporte le matériau à supraconduction sous la forme d'une couche ou d'une feuille.

3. Dispositif magnétique selon la revendication 2, caractérisé par le fait que le matériau à supraconduction de la structure à effet d'écran (21, 35, 42) est déposé sur un support (22, 37, 44).

4. Dispositif magnétique selon l'une des revendications 1 à 3, caractérisé par le fait que les bobines de champ de base (11 à 13) sont disposées sur un corps de bobine (4) à refroidissement simultané, sur le côté intérieur duquel est montée la structure à l'effet d'écran (20, 21, 24, 29, 31, 35, 42).

5. Dispositif magnétique selon l'une des revendications 1 à 4, caractérisé par le fait que la structure à effet d'écran (24) est réalisée à partir d'une feuille à supraconduction de forme rectangulaire (25), une zone de recouvrement (26) étant formée au niveau des bords longitudinaux de la feuille.

6. Dispositif magnétique selon l'une des revendications 1 à 4, caractérisé par le fait que la structure à effet d'écran (29, 31) est constituée par l'assemblage de plusieurs éléments formant écran (28, 32), préparais à l'avance.

7. Dispositif magnétique selon la revendication 6, caractérisé par le fait qu'avec les éléments formant écran (32) des zones de recouvrement (33, 34) sont formés au niveau des bords voisins.

8. Dispositif magnétique selon la revendication 6 ou 7, caractérisé par le fait que les différents éléments formant écran (28, 32) ont la forme d'un rectangle.

9. Dispositif magnétique selon l'une des revendications 1 à 8, caractérisé par le fait que la structure à effet d'écran (35, 42) est pourvue d'un dispositif de chauffage (38, 46, 52) qui est électriquement isolé par rapport au matériau à supraconduction de la structure à effet d'écran.

10. Dispositif magnétique selon la revendication 9, caractérisé par le fait que le dispositif de chauffage comporte une couche conductrice de chauffage (38, 44, 53) qui est couplée thermiquement au matériau à supraconduction de la structure à effet d'écran (35, 42), par l'intermédiaire d'une couche isolante (37, 45).

11. Dispositif magnétique selon l'une des revendications 1 à 10, caractérisé par le fait que l'écran contre le rayonnement (18, 18a, 18b) présente une constitution à fentes longitudinales de ses éléments métalliques.

12. Dispositif magnétique selon la revendication 11, caractérisé par le fait que l'écran contre le rayonnement (18a) comporte des tubes (56) à paroi mince pour le milieu de refroidissement, lesquels tubes sont disposés dans la direction axiale de l'écran, parallèlement entre eux et de manière à avoir une mauvaise conduction électrique entre eux (figure 12).

13. Dispositif magnétique selon la revendication 11, caractérisé par le fait que l'écran contre le rayonnement (18b) comporte de minces bandes métalliques (60) en un matériau thermiquement bon conducteur, lesquelles bandes sont disposées dans la direction axiale de l'écran, parallélement entre elles et se recouvrent, dans le sens périphérique, en étant isolées électriquement entre elles (figure 13).

14. Dispositif magnétique selon l'une des revendications 1 à 13, caractérisé par le fait que les bobines de champ de base à supraconduction (11 à 13) et ledit au moins un écran contre le rayonnement (18, 18a, 18b) sont disposés dans une cuve à vide (16) qui est constituée avec un matériau électriquement mauvais conducteur.

FIG 1

FIG 2

FIG 3

FIG 4

FIG 5

FIG 6

FIG 7

FIG 8

FIG 9

FIG 10

FIG 11

FIG 12

FIG 13